# FASCICULE DE BREVET EUROPEEN

(11) **EP 1 495 442 B1**
(45) Date de publication et mention de la délivrance du brevet: **01.08.2012**
(21) Numéro de dépôt: 03725201.2
(22) Date de dépôt: 16.04.2003
(51) Int. Cl.: G06K 19/077

(54) **PROCEDE DE CONDITIONNEMENT DE MICROCIRCUITS POUR CARTE A PUCE ET MODULE AINSI OBTENU**
VERFAHREN ZUM VERPACKEN VON MIKROSCHALTUNGEN FÜR CHIPKARTEN UND SO HERGESTELLTES MODUL
METHOD FOR ENCAPSULATION OF A CHIPCARD AND MODULE OBTAINED THUS

(30) Priorité: 18.04.2002 FR 0204899
(43) Date de publication de la demande: 12.01.2005
(73) Titulaire: Microconnections SAS, 78200 Mantes La Jolie (FR)
(72) Inventeur: RADENNE, Jean-Pierre, F-75016 PARIS (FR); DE MAQUILLE, Yannick, F-78100 SAINT GERMAIN EN LAYE (FR); MISCHLER, Jean-Jacques, F-27930 CIERREY (FR); MATHIEU, Christophe, F-78300 POISSY (FR)
(74) Mandataire: Jacquot, Ludovic R. G.
(86) Numéro de dépôt international: PCT/EP2003/050109
(87) Numéro de publication internationale: WO 2003/088139

(56) Documents cités:
- EP-A- 0 201 952
- EP-A- 0 359 632
- EP-A- 0 412 545
- EP-A- 0 952 545
- DE-A- 19 543 427
- US-A- 5 637 858
- US-A- 6 025 997
- US-B1- 6 306 240

## Description

La présente invention a pour objet une bande de module capable de recevoir des circuits intégrés , généralement appelé puce. Elle a également pour objet un procédé de fabrication d'une bande de module. En effet, avec la croissance des volumes de production des cartes à puce munies de tels modules, cartes à puce qui sont de plus en plus utilisées dans la vie quotidienne, les procédés de fabrication de ces modules ont été modifiés pour répondre à une demande quantitative, parfois au détriment de la qualité et de la fiabilité des produits obtenues.

Les cartes à puce sont obtenues en disposant un module microcircuit électronique dans un logement formé dans l'épaisseur de la carte. Ce module électronique comporte un microcircuit proposant une face supérieure de contact présentant des plages conductrices, d'un côté d'une face visible de la carte. L'autre face du module électronique porte une puce, cachée ensuite dans le logement de la carte. La puce est fixée et connectée d'un côté opposé à la face supérieure, à une face inférieure des plages conductrices.

Dans l'état de la technique, on connaît de l'enseignement du document FR-A-2 488 446 un module électronique compact prévu pour être monté dans une carte d'identification. Le module comporte une puce collée par sa base sur une première face d'une plaque métallique comportant des zones de contact. La puce est connectée à ces zones de contact par des fils conducteurs reliant une partie supérieure de la puce à ces zones de contact. Le module comporte un élément support ou substrat contre lequel peut être appuyée la plaque métallique. L'élément support comporte alors une ou des fenêtres pour permettre à la puce d'être collée et/ou connectée à la plaque métallique.

Le collage de la puce pose un problème, car il n'est pas fiable dans le temps. En effet, il nécessite de dispenser des points de colle calibrés et réguliers. Mais la présence de bulles dans le plan de colle peut fragiliser la résistance mécanique du module obtenu. En effet, pour remplir les conditions de productivité requises, on utilise des colles capables de réticuler rapidement et à des températures relativement hautes. Mais ces colles conduisent aussi à la formation de bulles et sont donc responsables de l'instabilité du montage de la puce sur la plaque métallique.

Pour donner une résistance mécanique au module, et par ailleurs protéger les fils conducteurs et la puce, on utilise un produit d'enrobage dans lequel on les enrobe. Par exemple, le produit d'enrobage est une résine. Il se rigidifie et se polymérise sous l'effet d'un traitement thermique ou d'une irradiation par des ondes infrarouges ou ultraviolettes. Ces résines d'enrobage elles-mêmes posent un problème. Leur mouillabilité est instable, et dépend pour partie des conditions extérieures qui ne peuvent pas être contrôlées à moindres coûts. La résine déposée forme un dôme du côté de la face inférieure, mais elle s'étale lors de son dépôt car elle n'est pas encore polymérisée. L'étalement de la goutte de résine conduit à une mauvaise résistance mécanique du module et à une mauvaise protection du microcircuit et de ses fils conducteurs.

L'écoulement de cette goutte pose un problème car elle rend de plus le module trop large. Donc, pour le positionnement de cette goutte, il est nécessaire de prévoir un pourtour autour de la goutte, pour réserver l'existence de zones périphériques de fixation du module à la carte. Ces zones de fixation sont ensuite collées contre un rebord prévu dans une feuillure latérale du logement de la carte à puce.

Par opposition, une résine à polymérisation tiède se polymérisant sous l'effet d'une irradiation d'ondes ultraviolettes fournit des résultats corrects vis-à-vis de la mouillabilité, et fournit donc une bonne protection de ce qu'elle enrobe. Mais cette résine ne fournit pas une résistance mécanique suffisante au module. De plus l'irradiation avec des ondes ultraviolettes peut perturber les zones mémoires des puces présentées sur ces modules.

Pour résoudre ce problème, on connaît des solutions pour utiliser des résines présentant de bonnes qualités de résistance mécanique, et permettre de diminuer le diamètre de la goutte d'une telle résine. Ces solutions mettent en oeuvre un barrage pour retenir l'épanchement de la goutte. Par exemple, le barrage peut être obtenu par sérigraphie d'un anneau de silicone déposé sur le pourtour de la zone de la plaque métallique devant recevoir la puce. Mais cette solution présente un rendement faible, et de plus ne limite pas parfaitement l'écoulement de la bulle si le plan est légèrement incliné.

Par ailleurs, on connaît du document US-A-5,989,941 l'utilisation d'un barrage pour canaliser le produit d'enrobage et permettre une amélioration de la dissipation de chaleur et de la tenue mécanique d'un module électronique. Les solutions incorporant un tel barrage sont également connues sous le nom de technique "dam & fill". Le barrage est retenu sur un support du module par une couche adhésive. Il y est retenu sur un côté de ce support qui est le même que celui sur lequel s'appuie la plaque de contacts avec laquelle la puce est connectée. Ce barrage correspond à un film comportant une fenêtre d'une dimension telle que la plaque de contact formant un modèle de circuit métallisé et la puce sont entièrement présentés à l'intérieur de cette fenêtre. Selon ce document, il est connu uniquement l'utilisation de film comportant au moins une pellicule conductrice. De plus, ce film n'est monté sur le module qu'une fois que le circuit métallique a été réalisé, et après que la puce a été connectée à ce circuit.

Le film comporte par exemple une longue bande, dont l'une des faces est enduite de matière adhésive au moyen d'un applicateur. Selon ce document, le film est ensuite découpé pour que des fenêtres y soient formées. Les fenêtres du film sont prévues pour venir coopérer avec différentes zones d'un support, chaque zone comportant un circuit métallique et une puce connectée avec son circuit, le support comportant toujours des ailes pour sa fixation à la carte à puce. Le film est collé sur le support de telle sorte que chaque fenêtre est disposée autour d'un seul circuit. La fenêtre permet alors, vu l'épaisseur du film de limiter l'épanchement de matière d'enrobage lorsque la goutte de résine est déposée sur le circuit muni de sa puce.

Le module électronique obtenu selon cet enseignement, pour être ensuite monté dans une carte d'identification, doit être enduit d'une colle spécifique qui permet d'adhérer au fond d'un logement de la carte d'identification, du fait de la nature même du type de film utilisé.

Le problème des micromodules de l'état de la technique réside dans le fait que, même munis d'un film limitant l'écoulement de la goutte de résine, ils nécessitent une étape longue, fastidieuse, et présentant un faible taux de rendement, qui correspond à l'étape d'encartage du micromodule. En effet, pour réaliser l'encartage du micromodule, on utilise un deuxième film enduit de colle dite hot-melt que l'on prédécoupe dans une première étape pour y former des fenêtres. Ensuite, on lamine à chaud ce film de colle sur le micromodule, et enfin au cours d'une troisième étape on active la colle de ce film pour un encartage définitif du micromodule dans la carte.

La première étape est à faible rendement du fait que les ciseaux adhèrent au film de colle même refroidi, et empêchent une manipulation plus rapide relativement au film. Cette première étape est donc incompatible avec les cadences exigées pour la production de masse des cartes à puce. De plus pour garantir un positionnement correct du film de colle sur le micromodule, il faut prévoir un échenillage de l'un par rapport à l'autre, ce qui induit un processus lent. Avec un processus rapide, lorsque le laminage du film de colle a lieu, il y a un taux important de rejet. Le rejet est à cette étape très coûteux, car aucun des composants rejetés ne pourra être réutilisé.

L'utilisation d'un tel film de colle est nécessaire pour obtenir une cadence de fabrication supérieure aux procédés dans lesquels chaque micromodule est encollé individuellement. Mais l'utilisation d'un tel film de colle est obligatoire pour pouvoir fixer le micromodule au fond de son logement, même si sa fiabilité est limitée dans le temps.

La demande de brevet européen EP0201952 A1 décrit un procédé pour fabriquer une carte d'identification électronique. Un ruban adhésif double face comportant des trous traversant est collé sur un film porteur de pistes conductrices. Des circuits intégrés sont montés à travers les trous du ruban dans des cavités du film sur les pistes conductrices. Des vignettes sont ensuite découpées dans le film et sont placées dans un logement d'une carte.

Le brevet américain US5637858 décrit un procédé de fabrication en continu de modules dans lequel on vient d'abord connecter les circuits intégrés aux pistes d'une bande continue de piste de contact et dans lequel on vient ensuite appliquer une bande pourvue de fenêtres sur la bande de piste de contact supportant déjà les circuits intégrés. Le circuit intégré est supporté par les pistes de contact.

La présente invention se propose de remédier aux problèmes invoqués ci dessus en redéfinissant le conditionnement du microcircuit électronique, afin de faciliter l'encartage ultérieur du module comportant ce microcircuit. Ainsi, on améliore le rendement de l'étape de conditionnement du module électronique, et par ailleurs on augmente la fiabilité longue durée du montage d'un tel module électronique dans une carte. La fiabilité du produit fini est augmentée du fait que la fiabilité du collage du module dans la carte est d'une part augmenté, et que la fiabilité du collage de la puce au dos du microcircuit électronique est d'autre part améliorée. En effet, l'invention prévoit de déporter sur le module microcircuit électronique tous les moyens de collage.

L'invention a donc pour objet une bande de module selon la revendication 1.

L'invention a donc également pour objet un procédé de fabrication d'une bande de module selon la revendication 6.

L'invention sera mieux comprise à la lecture de la description qui suit et à l'examen des figures qui l'accompagnent. Celles ci ne sont présentées qu'à titre indicatif et nullement limitatif de l'invention. Les figures montrent :
- Figure 1: une vue en coupe longitudinale d'un module électronique selon l'invention monté dans un support à puce, typiquement une carte à puce ;
- Figure 2: une vue en perspective de dessous d'un module électronique selon l'invention.

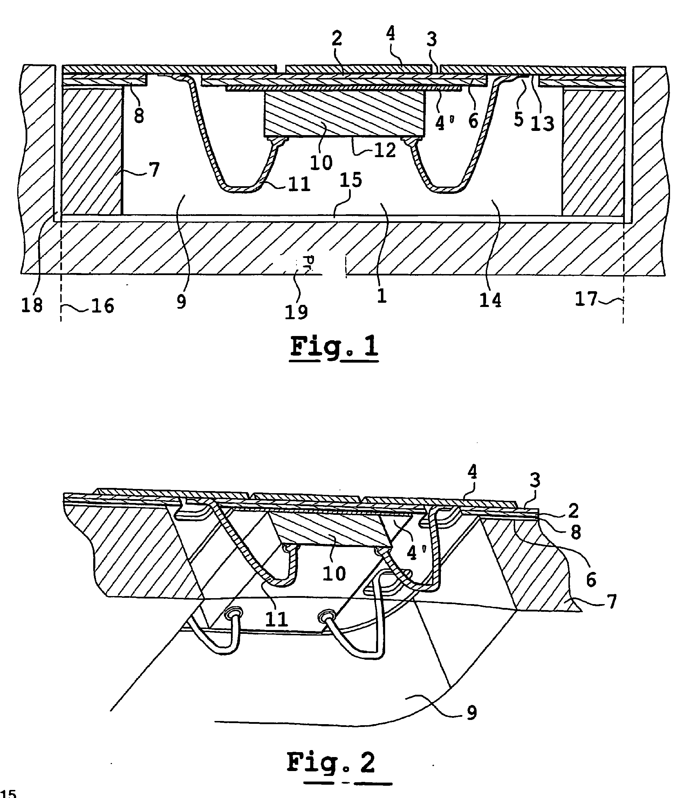

La figure 1 montre un module microcircuit électronique 1 selon l'invention. Le module 1 comporte un substrat 2 formant un plan. Le substrat 2 est de préférence réalisé dans un matériau diélectrique, par exemple à partir d'un film polyester, notamment de polyéthylène téréphtalate (PET), polyéthylène naphtalate (PEN), ou bien encore à partir de polyimides. Le substrat a dans un mode particulier de réalisation une épaisseur de l'ordre de 25 micromètres

Sur une première face 3 du substrat 2, le module 1 présente une plage de contact 4. La plage de contact 4 est par exemple celle d'un circuit imprimé. Ce circuit imprimé est obtenu en laminant une couche de cuivre d'une épaisseur de 18 à 35 micromètres sur le substrat. Cette couche de cuivre est retenue sur la première face 3 par un adhésif préalablement déposé. Le substrat 2 muni de sa couche de cuivre est ensuite généralement gravé chimiquement pour former le circuit imprimé 4.

Le substrat 2 présente par ailleurs des trous 5, formés au travers du plan formé par le substrat, et permettant de relier sa première face 3 à une deuxième face 6. La deuxième face 6 est opposée et parallèle à la première face 3.

Le module microcircuit 1 comporte du côté de la deuxième face 6, un masque 7 épais, collé avec un moyen adhésif 8 sur cette deuxième face 6. Le masque 7 correspond à un film épais de l'ordre de 350 micromètres dans lequel est formé au moins une fenêtre 9. L'épaisseur du masque est supérieure à la hauteur d'un circuit intégré 10. La fenêtre 9 est suffisamment grande pour permettre de fixer ultérieurement le circuit intégré 10, ou puce 10, directement sur la deuxième face 6 du substrat. Le masque 7 est de préférence réalisé à partir d'un polymère plastique du type polyéthylène téréphtalate (PETG) ou polychlorure de vinyle (PVC). Il peut également être réalisé en papier. Le choix du matériau dans lequel est réalisé le masque 7 dépend de l'utilisation ultérieure du module électronique ainsi conçu. On choisira en effet une matière pour le masque 7 qui permette d'être facilement collée ou soudée dans un dispositif complémentaire, par exemple une carte à puce.

Dans un exemple, le moyen adhésif 8 se présente sous la forme d'une couche de résine polymère thermoplastique (par exemple de type polyester) réactivable à température moyenne (par exemple entre 100 et 130°C).

Le masque 7 est formé par une bande pleine. Dans une variante cette bande pleine est préalablement ajourée avant d'être monté sur la deuxième face 6. De préférence, le masque 7 se présente sous la forme d'une bande pleine présentant plusieurs fenêtres telles que 9. La bande pleine comporte ainsi une succession de fenêtres 9 formant un motif répétitif, et séparées les unes des autres par des parties pleines situées entre les fenêtres et par des parties pleines continues sur les bords des fenêtres, dans le sens de la bande. Ces parties pleines entourant une fenêtre 9 sont destinées à venir encadrer une zone distincte du substrat 2. Chaque zone distincte du substrat 2 correspond à un ensemble de plages de contact telles que 4 propres. Un tel ensemble de plages de contact 4, pour lesquelles une fenêtre 9 du masque 7 a été correctement disposée, est destiné à recevoir une puce telle que 10.

Le masque 7 doit être très précisément positionné sur la deuxième face 6, car sa position est déterminante pour pouvoir correctement monter la puce 10 sur cette deuxième face et pouvoir la connecter avec les plages de contact telles que 4 par l'intermédiaire des trous tels que 5. Cependant le masque est déposé avant que la puce 10 ne soit installée, en cas de mauvais positionnement, le coût de ce type d'erreur est moindre.

Pour obtenir un positionnement très précis du masque 7 relativement à la position de la zone dans laquelle la puce 10 doit être déposée et connectée, on utilise une technique de laminage. A cet effet, dans un mode de réalisation préféré, la bande portant le masque 7 comporte des orifices latéraux de positionnement (régulièrement disposé le long de la bande) formant des index dans lesquels un dispositif complémentaire d'avance de la bande peut coopérer pour garantir le positionnement du masque 7 au cours du laminage.

Selon un premier mode de réalisation, pour retenir le masque 7 ajouré contre la deuxième face 6 du substrat 2, on a au préalable enduit cette deuxième face 6 avec un moyen adhésif 8. Dans ce cas, le moyen adhésif 8 peut même être déposé avant d'avoir réalisé le circuit imprimé 4. Par ailleurs le moyen adhésif 8 peut enduire l'intégralité de la deuxième face 6, même les zones qui correspondent aux fenêtres 9 du masque 7 (sauf à l'endroit des trous 5). Le masque 7 est ensuite laminé par des rouleaux contre le moyen adhésif 8 sur le substrat 2.

Selon un deuxième mode de réalisation, on dépose le moyen adhésif 8 contre l'une des faces du masque 7, celle destinée à être plaquée contre la deuxième face 6. Les fenêtres 9 sont réalisées ensuite, après avoir enduit le moyen adhésif 8, ce qui permet de garantir une répartition homogène de la colle et évite d'enduire la deuxième face du substrat. De la même manière par une technique de laminage en continu entre deux bobines, on colle le masque 7 sur le substrat 2. Dans ce deuxième cas, il peut être nécessaire de prévoir un deuxième moyen adhésif pour retenir la puce 10 contre cette deuxième face 6.

Dans un mode préféré de réalisation, la puce 10 est montée dans la fenêtre 9 et collée au moyen du premier moyen adhésif 8 contre la deuxième face 6 du substrat 2. La puce 10 est de préférence montée après que le masque 7 ait été déposé contre le substrat 2. Dans les deux modes, toutefois, en variante non couverte par les revendications, elle pourrait être montée avant. Pour obtenir un collage efficace et certain, on réactive la colle à l'endroit où la puce doit être placée. Dans une variante, présentée figure 2, on utilise une deuxième couche de colle 4' pour coller la puce 10 sur le substrat 2.

Ensuite pour connecter la puce 10 avec les plages de contact 4, on utilise de préférence la technologie de connexion par fils, dite "wire bonding", dans laquelle on relie par des fils métalliques 11, par exemple dorés, une plage sur une surface supérieure 12 de la puce 10 à une face inférieure 13 des plages de contact 4. Les fils 11 utilisés sont par exemple d'un diamètre de l'ordre de 20 micromètres et les liaisons aux deux extrémités sont réalisées par thermosoudures ultrasoniques. Les fils 11 traversent le substrat 2 à l'endroit des trous 5. Un montage de la puce par une technologie de composant monté en surface, CMS, dite "Flip chip", est aussi envisageable. Dans ce cas, la puce est montée sur le substrat avant la mise en place du masque.

L'épaisseur du masque 7 est supérieure à la hauteur de la puce une fois celle-ci fixée sur le substrat 2. Ainsi, du fait de la présence des bordures formées par les encadrements de la bande du masque 7, la puce 10 est protégée. Pour une plus grande protection, on enrobe la puce 10 ainsi que les fils 11 dans une résine d'enrobage 14.

La résine d'enrobage 14 se présente sous forme liquide et se rigidifie et se durcit en se polymérisant. L'ouverture de la fenêtre 9 est orientée vers le haut pour cet enrobage. L'écoulement de la résine 14 déposée dans le creux formé par la fenêtre 9 permet de combler les espaces vides. La polymérisation peut être accélérée par un traitement par voie thermique ou infra rouge, ou éventuellement par irradiation ultraviolette. La résine 14 est de préférence irradiée par des ondes ultraviolettes, pour limiter les effets indésirables sur le masque dans le cas où celui-ci est réalisé en PVC.

Le module microcircuit 1 ainsi formé présente alors une face de contact, avec les plages de contact telles que 4, et une face arrière munie du masque 7, la face arrière étant parallèle à la face de contact. Pour monter un tel microcircuit 1 dans un dispositif complémentaire (par exemple une carte à puce), il faut d'abord l'équiper de la puce 10 pour former un module électronique complet, et ensuite placer le module complet dans un logement du dispositif complémentaire. Dans l'invention, le logement du dispositif complémentaire est uniquement parallélépipédique. Ce logement forme une cavité simple, sans feuillure, de telle sorte qu'un fond de ce logement soit de même taille qu'un module individualisé. Le matériau du fond du logement est compatible avec un matériau du masque 7. Par compatible, on entend le fait que les deux matériaux puissent être collés de manière certaine l'un avec l'autre au moyen de colle classique, ou en mettant en oeuvre des techniques de soudure par ultrasons.

Dans le cas où le dispositif complémentaire est une carte d'identification, type carte à puce, celle ci est de préférence réalisée dans des matériaux plastiques compatibles avec ceux du masque. Ainsi des colles à base de cyanoacrylate peuvent être utilisées. Le collage peut également être obtenu en s'affranchissant de colle et en utilisant la technologie de vibrations ultrasonores.

La séparation des modules, à partir de la bande, peut se produire avant ou après mise en place des puces dans chaque fenêtre cavité 9. Dans le cas préféré, la séparation individualisation des modules microcircuits est entreprise après mise en place de ces puces et remplissage de la fenêtre cavité 9, pour chacun d'eux, avec la résine d'enrobage.

Dans ce cas préféré, après l'enrobage et avant la séparation on dépose sur la totalité de la bande (du côté sur lequel les puces viennent d'être enrobées) une couche 15 de colle, elle aussi de préférence de type à fusion à chaud, dite hot melt. Puis on sépare les modules, par exemple par des sciages tels que 16 et 17, ou par des matriçages. Chaque module se présente alors comme un parallélépipède rectangle dont une face possède une couche 15 de colle. On saisit alors un tel module par les chants, ou par une pipette aspirante par le dessus, par les plaques 4. On le place ensuite dans un logement 18 parallélépipédique correspondant d'une carte à puce 19 ou d'un support à puce autre. Le logement 18 est à flancs droits, sans feuillures.

En variante, la couche 15 est mise en place en même temps que la couche 8. Elles sont ensuite matricées en même temps que les fenêtres 9. Puis le substrat 2 est laminé contre la bande 7. Puis les puces 10 sont montées. Puis l'enrobage 14 est effectué, puis le module est individualisé et, là aussi déjà préencollé, il est monté dans la cavité 18 d'une carte à puce.

Dans ces deux cas, le module se présente sous la forme d'un parallélépipède. Il ne comporte pas d'ailes comme dans l'état de la technique. Ces ailes, zones périphériques de fixation, servaient de moyen de montage des modules dans des cavités à feuillure des cartes. Ces ailes présentaient cependant l'inconvénient de conduire à des arrachements. Dans l'invention, le collage de la puce dans la carte est effectué par le fond. La mise en place générale et calibrée de la couche de colle 15 garantit son épaisseur, et donc le respect facile des tolérances requises pour la planéité d'affleurement des plages 4 au-dessus de la carte. L'absence d'ailes élimine les problèmes d'arrachage autrement rencontrés.

Ainsi dans un premier mode, on pose la bande masque sur une bande de substrat, on place les puces dans les cavités, on enrobe les puces en remplissant les trous du masque, on met la couche 15 en place et on sépare les modules parallélépipédiques préencollés. Dans ce cas, ces couches de colle sont de préférence des couches de type à fusion à chaud, qui peuvent être réactivées par chauffage.

Dans un deuxième mode, on place des couches de colle 8 et 15 de chaque côté d'une bande de masque, non encore ajouré, on réalise les fenêtres 9 à travers le masque et les couches de colle, on place le masque préencollé sur un substrat 2 en faisant correspondre les fenêtres 9 avec le dos des métallisations 4, on met les puces en place, on enrobe les puces et on sépare là aussi les modules parallélépipédiques préencollés.

En variante chaque couche de colle peut être remplacée par un ruban à collage double face. En variante encore le module individualisé peut être collé au fond d'une cavité simplement parallélépipédique d'une carte à puce par un collage avec une colle cyanocrylate ou par collage par ultrasons d'une face de base du module dans ce fond de cavité.

## Revendications

1. Bande de module capable de recevoir des circuits intégrés ultérieurement comportant :
- un substrat (2),
- au moins une plage de contact (4) sur une première face (3) du substrat,
- un masque comprenant des fenêtres pour recevoir les circuits intégrés,
- un premier moyen adhésif (8) retenant une première face du masque (7) contre une deuxième face du substrat,
- et un deuxième moyen adhésif dispensé sur une deuxième face du masque,
la bande de module étant **caractérisée en ce que** la deuxième face (6) du substrat est capable de supporter les circuits intégrés (10).

2. Bande de module selon la revendication 1 dans laquelle le masque est réalisé dans un matériau identique à celui d'une carte prévue pour recevoir un module individualisé obtenu à partir de ladite bande, par exemple à partir d'un polymère de type polyester ou polychlorure de vinyle.

3. Bande de module selon les revendications 1 ou 2 dans laquelle le masque a une épaisseur supérieure à une hauteur du circuit intégré qu'elle est capable de recevoir.

4. Bande de module selon l'une des revendications 1 à 3 dans laquelle le premier moyen adhésif est apte à retenir le circuit intégré à la deuxième face du substrat.

5. Bande de module selon la revendication 4 dans laquelle le premier moyen adhésif comprend en outre une colle (4') apte à retenir le circuit intégré à la deuxième face du substrat.

6. Procédé de fabrication d'une bande de module selon l'une des revendications 1 à-4 à 5 comportant les étapes suivantes :
a) réaliser des plages de contact (4) sur une première face (3) d'une bande de substrat (2) ;
b) disposer un premier moyen adhésif (8) entre une deuxième face du substrat capable de supporter des circuits intégrés et une première face d'une bande masque (7) comportant des fenêtres, pour retenir le masque contre la deuxième face de sorte que les fenêtres soient en vis-à-vis des plages de contact
c) disposer un deuxième moyen adhésif sur la une deuxième face du masque,

## Claims

1. Module tape capable of subsequently receiving integrated circuits comprising:
- a substrate (2),
- at least one contact area (4) on a first face (3) of the substrate,
- a mask comprising windows for receiving the integrated circuits,
- a first adhesive means (8) holding a first face of the mask (7) against a second face of the substrate,
- and a second adhesive means arranged on a second face of the mask,
the module tape being **characterized in that** the second face (6) of the substrate is capable of supporting the integrated circuits (10).

2. Module tape according to Claim 1, in which the mask is produced in a material identical to that of a card designed to receive an individualized module obtained from said tape, for example made of a polymer of polyester or polyvinyl chloride type.

3. Module tape according to Claim 1 or 2, in which the mask has a thickness greater than a height of the integrated circuit that it is capable of receiving.

4. Module tape according to one of Claims 1 to 3, in which the first adhesive means is suitable for holding the integrated circuit on the second face of the substrate.

5. Module tape according to Claim 4, in which the first adhesive means also comprises a glue (4') suitable for holding the integrated circuit on the second face of the substrate.

6. Method for fabricating a module tape according to one of Claims 1 to 5, comprising the following steps:
a) producing contact areas (4) on a first face (3) of a substrate tape (2);
b) arranging a first adhesive means (8) between a second face of the substrate capable of supporting integrated circuits and a first face of a mask tape (7) comprising windows, to hold the mask against the second face so that the windows are facing the contact areas
c) arranging a second adhesive means on a second face of the mask.

## Patentansprüche

1. Modulband, das später integrierte Schaltungen aufnehmen kann, welches aufweist:
- ein Substrat (2),
- mindestens einen Kontaktbereich (4) auf einer ersten Seite (3) des Substrats,
- eine Maske, die Fenster enthält, um die integrierten Schaltungen aufzunehmen,
- ein erstes Haftmittel (8), das eine erste Seite der Maske (7) gegen eine zweite Seite des Substrats hält,
- und ein zweites Haftmittel, das auf einer zweiten Seite der Maske verteilt ist,
wobei das Modulband **dadurch gekennzeichnet ist, dass** die zweite Seite (6) des Substrats die integrierten Schaltungen (10) tragen kann.

2. Modulband nach Anspruch 1, wobei die Maske aus einem Material gleich demjenigen einer Karte hergestellt ist, die zur Aufnahme eines individualisierten Moduls vorgesehen ist, das ausgehend von dem Band erhalten wird, zum Beispiel aus einem Polymer von der Art Polyester oder Polyvinylchlorid.

3. Modulband nach den Ansprüchen 1 oder 2, wobei die Maske eine größere Dicke als eine Höhe der integrierten Schaltung hat, die sie aufnehmen kann.

4. Modulband nach einem der Ansprüche 1 bis 3, wobei das erste Haftmittel die integrierte Schaltung an der zweiten Seite des Substrats halten kann.

5. Modulband nach Anspruch 4, wobei das erste Haftmittel außerdem einen Klebstoff (4') enthält, der die integrierte Schaltung an der zweiten Seite des Substrats halten kann.

6. Verfahren zur Herstellung eines Modulbands nach den Ansprüchen 1 bis 5, das die folgenden Schritte aufweist:
a) Herstellen der Kontaktbereiche (4) auf einer ersten Seite (3) eines Substratbands (2);
b) Aufbringen eines ersten Haftmittels (8) zwischen einer zweiten Seite des Substrats, die integrierte Schaltungen tragen kann, und einer ersten Seite eines Maskenbands (7), das Fenster aufweist, um die Maske so gegen die zweite Seite zu halten, dass die Fenster sich gegenüber den Kontaktbereichen befinden,
c) Aufbringen eines zweiten Haftmittels auf einer zweiten Seite der Maske.
